(19) Europäisches Patentamt
European Patent Office
Office européen des brevets

(11) **EP 2 506 023 B1**

(12) **EUROPEAN PATENT SPECIFICATION**

(45) Date of publication and mention of the grant of the patent:
**04.09.2013 Bulletin 2013/36**

(51) Int Cl.:
***G01R 31/36*** *(2006.01)*     ***H01M 10/42*** *(2006.01)*

(21) Application number: **11002741.4**

(22) Date of filing: **01.04.2011**

(54) **Battery tester for cold cranking amperes test**

Batterietestgerät für Kaltstartstromtest

Testeur de batterie pour essai de courant de démarrage à froid

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(43) Date of publication of application:
**03.10.2012 Bulletin 2012/40**

(73) Proprietor: **DHC Specialty Corp.**
**Taipei (TW)**

(72) Inventors:
• **Sheng, Hsien-Fang**
**Nei Hu Dist.**
**Taipei (TW)**

• **Hsiao, Yuan-Chen**
**Nei Hu Dist.**
**Taipei (TW)**

(74) Representative: **Hauck Patent- und Rechtsanwälte**
**Neuer Wall 50**
**20354 Hamburg (DE)**

(56) References cited:
**US-A- 4 707 795**     **US-A- 5 773 977**
**US-A1- 2006 244 423**     **US-A1- 2009 237 086**
**US-B1- 6 259 254**     **US-B1- 6 369 577**

## Description

### 1. Field of the Invention

The present invention relates to the field of a battery tester, and more particularly to a battery tester providing high precision detecting results.

### 2. Description of Related Art

There are many types of the rechargeable batteries with different capacities on the market. The battery tester is used to detect the residual capacity of the rechargeable battery to determine the health of the rechargeable battery. However, the conventional battery tester uses only one method to detect different rechargeable batteries and inaccurate testing results will likely occur.

In general, the conventional battery tester uses 1/2 Cold Cranking Amps (hereinafter CCA) testing method to detect the health of the rechargeable battery, the method having steps of: (a) adding a load to the two electrodes of the battery to discharge the battery by loading the amperes of 1/2 CCA for 15 seconds; and (b) determining the health of the battery according to the discharging diagram.

In the conventional testing method implemented by the battery tester, the resistance of the load and the duration of adding load to the battery are fixed. Therefore, when the battery tester respectively detects rechargeable batteries with different capacities, figures of the discharging diagrams are not precise. The testing precision of the conventional battery tester is not ideal for all rechargeable batteries.

A battery charger with the features of the preamble of claim 1 has become known from US 2006/244423 A1. Other similar battery testers are described in US 6369577 B1, US 6259254 B1, US 5773977 A, US 4707795 A and US 2009/237086 A1.

To overcome the shortcomings, the present invention provides a battery tester with high precision to mitigate or obviate the aforementioned problems.

Based on the foregoing drawbacks of the conventional battery tester, the main objective of the present invention is to provide a battery tester with high precision.

The battery tester has a casing having an input device and two detecting wires, a microprocessor, a loading unit and a battery power status detecting unit. The microprocessor stores a strategic decision process therein to determine a loading time for a battery according to the cold cranking amperes of the battery, the battery voltage and detection requirements including a 1/N CCA and a loading time input from the input device. Therefore, the battery tester detects batteries with different cold cranking amperes and has accurate detecting results.

Other objectives, advantages and novel features of the invention will become more apparent from the following detailed description when taken in conjunction with the accompanying drawings.

IN THE DRAWINGS

Fig. 1 is a perspective view of a battery tester in accordance with the present invention;
Fig. 2 is a functional block diagram of a battery tester in accordance with the present invention;
Fig. 3 is a flow chart of a strategic decision process implemented in Fig. 1;
Fig. 4 is a testing diagram of the battery tester in accordance with the present invention; and
Fig. 5 is a flow chart of a detecting process in accordance with the present invention.

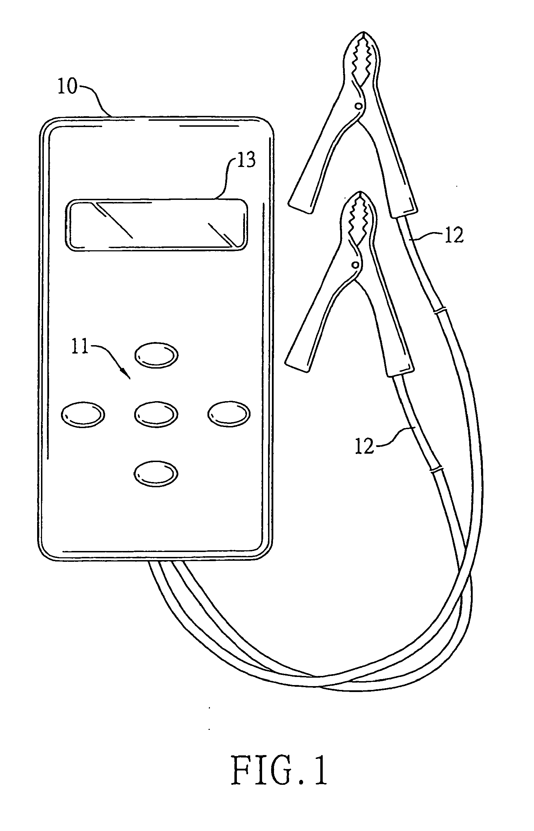

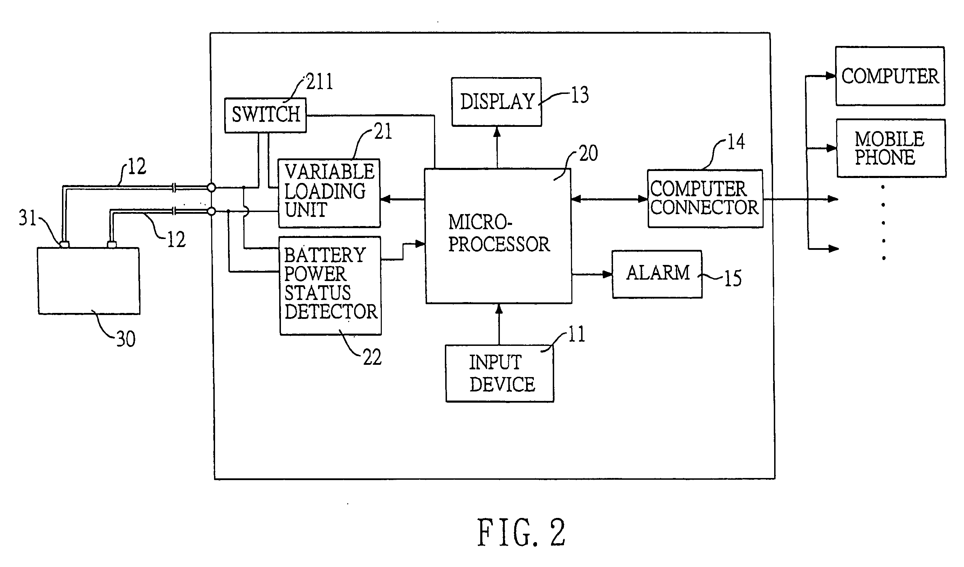

With reference to Figs. 1 and 2, a preferred embodiment of a battery tester in accordance with the present invention has a casing 10, a microprocessor 20, a loading unit 21, a switch 211 and a battery power status detecting unit 22.

The casing 10 has an input device 11 and two detecting wires 12. A user uses the input device 11 to select a specific battery capacity. The detecting wires 12 are respectively and electronically connected to two electrodes 31 of the battery 30. In the preferred embodiment, the two detecting wires 12 respectively clip to the two electrodes 31 of the battery 30. In addition, the casing 10 further has a display 13, a computer connector 14 and an alarm 15. The computer connector 14 is used to connect to an external electronic device such as a computer or mobile phone.

The microprocessor 20 stores a strategic decision process and a detecting process therein.

The loading unit 21 is electronically connected to the microprocessor 20 and the two wires 12. The loading unit 21 is electronically connected to the electrodes 31 of the battery 30 through the two wires 12 to detect voltage and current changes of the battery 30 and then responds with the voltage and current values to the microprocessor 20.

The switch 211 is electronically connected between one of the detecting wires 12 and the loading unit 21 and is controlled by the microprocessor 20.

The battery power status detecting unit 22 is electronically connected between the detecting wires 12 and the microprocessor 20 to detect the battery voltage value and/or current value. Further, the battery power status detecting unit 22 may be built-in the microprocessor 20.

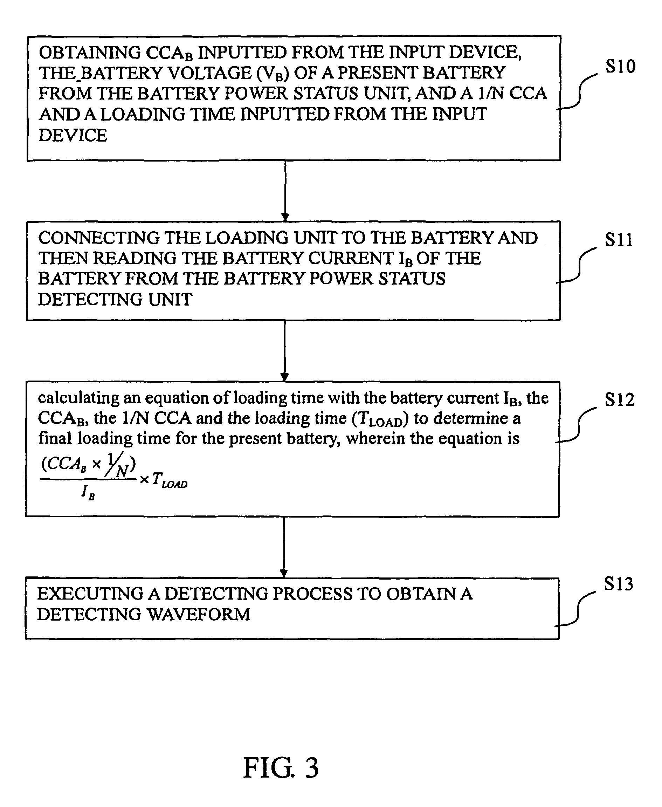

With further reference to Fig. 3, the microprocessor 20 executes a strategic decision process having the following steps of:

(a) obtaining cold cranking amperes ($CCA_B$) of the battery from the input device 11, the battery voltage ($V_B$) of a present battery 30 from the battery power status unit 22, and the preset detection requirements including a 1/N CCA and a loading time ($T_{LOAD}$)inputted from the input device 11 (S10);

(b) connecting the loading unit 21 to the battery 30 and then reading the battery current $I_B$ of the battery 30 from the battery status detecting unit 22 (S 11);

(c) calculating an equation of loading time with the battery current $I_B$, the cold cranking amperes ($CCA_B$), the preset detection requirements 1/N CCA and the loading time ($TL_{OAD}$) to determine a final loading time for the present battery 30 (S12), wherein

the equation is $\dfrac{(CCA_B \times \frac{1}{N})}{I_B} \times T_{LOAD}$, and

(d) executing a detecting process to obtain a detecting waveform (S13).

Example 1: If the user detects the health of the present battery 30 with 12 V/1000 CCA, and the preset detection requirements are 1/N CCA = 1/2 CCA, loading time $T_{LOAD}$ = 15sec and the loading unit 21 has a fixed resistance of 0.12 ohm, the microprocessor 20 previously turns on the switch 211 so the loading unit 21 is connected to the battery 30. Then the microprocessor 20 obtains the battery current ($I_B$=100A). Since the batteries with different capabilities require different loading times, the processor 20 calculates the equation of loading time:

$\dfrac{(1000 \times \frac{1}{2})}{100} \times 15 = 75\sec$. Therefore, the proper final loading time for the present battery 30 with the 12V /1000 CCA is 75sec.

Example 2: If the user detects the health of the present battery 30 with 12 V/900 CCA, and the preset detection requirements are 1/N CCA = 1/3 CCA, loading time $T_{LOAD}$ = 20sec and the loading unit 21 has a fixed resistance of 0.08 ohm, the microprocessor 20 previously turns on the switch 211 so the loading unit 21 connects to the battery 30. Then the microprocessor 20 obtains the battery current ($I_B$=150A). The microprocessor 20 calculates the equation of loading time:

$\dfrac{(900 \times \frac{1}{3})}{150} \times 20 = 40\sec$. Therefore, the proper final loading time for the present battery 30 with the 12V /900 CCA is 40sec.

Based on the two examples, the battery tester uses a fixed loading unit, but the final loading time is determined according to the cold cranking amperes of the battery and the preset detection requirements including the 1/N CCA and the loading time. In the detecting process, the battery can continuously discharge for the final loading time and the microprocessor presets a power threshold and obtains enough discharging power status and a high precision detecting curve to analyze the health of the battery according to the detecting waveform.

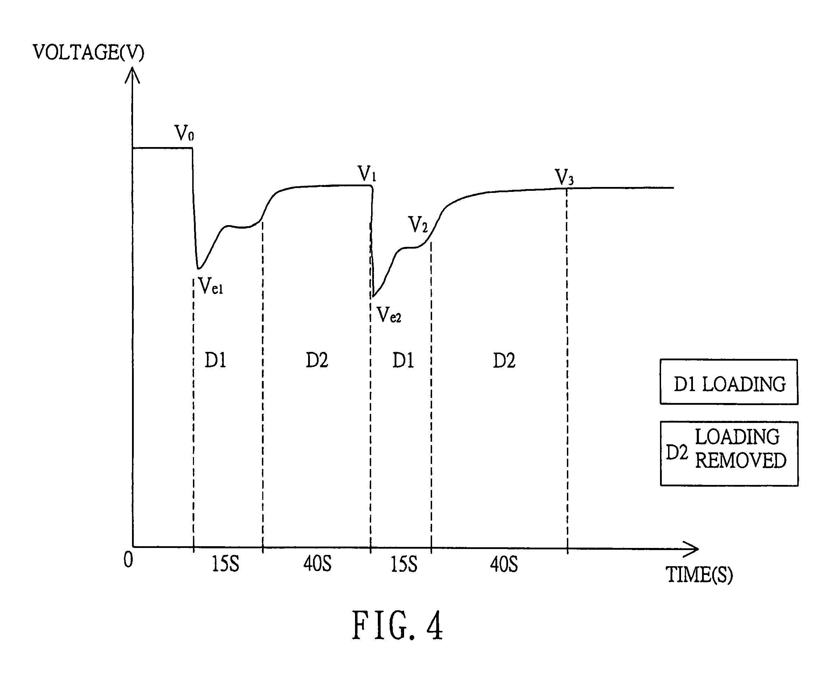

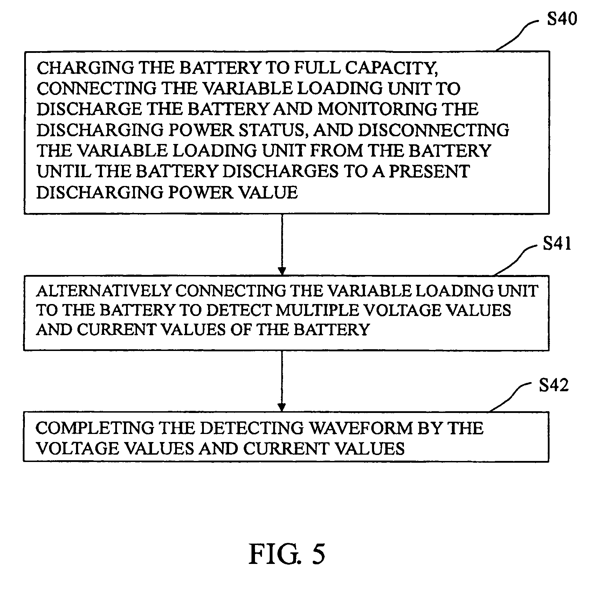

With reference to Figs. 1, 4 and 5, the detecting curve obtained by the microprocessor 20 and the flow chart of the detecting process are shown. In detecting process, the battery 30 is first charged to full capacity and just removed from a charger. The loading unit 21 is then connected to the battery 30. The microprocessor 20 detects a discharging power of the battery 30 through the loading unit 21 and monitors whether a discharging power of the battery 30 achieves a present power value ($V_{e2}$). When the discharging power achieves the present power value, the switch 211 are removed from the battery 30 so the loading unit 21 is disconnected from the battery (S20). Therefore, the battery 30 has no floating charging voltage. Then, the loading unit 21 is alternatively connected to the battery 30 to detect multiple voltage values and current values of the battery 30 (S21). Finally, the detecting curve is completed by the voltage values and/or current values and the microprocessor determines the health of the battery according to the detecting curve (S22).

Even though numerous characteristics and advantages of the present invention have been set forth in the foregoing description, together with details of the structure and function of the invention, the disclosure is illustrative only. Changes may be made in detail, especially in matters of shape, size, and arrangement of parts within the principles of the invention to the full extent indicated by the broad general meaning of the terms in which the appended claims are expressed.

## Claims

1. A battery tester, comprising a casing (10) having an input device (11), two detecting wires (12) adapted to selectively connect to two electrodes (31) of a battery (30), a microprocessor (20), a loading unit (21) electronically connected to the microprocessor (20) and connected to the detecting wires (12), and a battery power status detecting unit (22), **characterized in**:

   the input device (11) providing different options of cold cranking amperes $CCA_B$ of the battery (30) and detection requirements including a 1/N CCA and a loading time $T_{LOAD}$;
   the microprocessor (20) storing a strategic decision process therein;
   a switch (211) electronically connected between one of the detecting wires (12) and the loading unit (21), and controlled by the microprocessor (20); and
   the battery power status detecting unit (22) electronically connected to the microprocessor (20) to detect a voltage and current of the battery (30) and reporting the voltage and current to the microprocessor (20);

wherein the microprocessor (20) is adapted to execute the following steps of the strategic decision process:

(a) obtaining cold cranking amperes $CCA_B$ from the input device , the battery voltage ($V_B$) of a present battery from the battery power status unit (22), the 1/N CCA and the loading time $T_{LOAD}$ from the input device (11) (S10);
(b) connecting the loading unit (21) to the battery (30) and then reading the battery current $I_B$ of the battery (30) from the battery power status detecting unit (22) (S 11);
(c) calculating an equation of loading time with the battery current $I_B$, the cold cranking amperes $CCA_B$, the 1/N CCA and the loading time $T_{LOAD}$ to determine a final loading time for the present battery (30) (S12), wherein the equation is

$$\frac{(CCA_B \times \sqrt[1]{N})}{I_B} \times T_{LOAD} \text{, and}$$

(d) executing a detecting process to obtain a detecting waveform (S 13).

2. The battery tester as claimed in claim 1, wherein the microprocessor (20) further stores a detecting process and is adapted to execute the following steps of the detecting process:

(a) charging the battery (30) to full capacity and removing the battery (30) from a charger (S20);
(b) connecting the loading unit (21) to discharge the battery (30) and monitoring the discharging power status (S20);
(c) disconnecting the loading unit (21) from the battery (30) until a present power of the battery (30) is lower than a power threshold (S20);
(d) alternatively connecting the loading unit (21) to the battery (30) to detect multiple voltage values and current values of the battery (30) (S21); and
(e) completing the detecting waveform by the voltage values and current values (S22).

3. The battery tester as claimed in claim 2, wherein the casing (10) further comprises a display (13), a computer connector (14) and an alarm (15).

**Patentansprüche**

1. Batterietestgerät, umfassend ein Gehäuse (10) mit einer Eingabevorrichtung (11), zwei Ermittlungsdrähte (12), die wahlweise mit zwei Elektroden (31) einer Batterie (30) verbindbar sind, einen Mikroprozessor (20), eine elektronisch mit dem Mikroprozessor (20) verbundene und mit den Ermittlungsdrähten (12) verbundene Belastungseinheit (21) und eine Einheit (22) zur Ermittlung des Batterieleistungszustandes, **gekennzeichnet dadurch:**

**dass** die Eingabevorrichtung (11) verschiedene Optionen von Kaltstart-Stromstärken $CCA_B$ der Batterie (30) sowie Ermittlungsanforderungen beinhaltend ein 1/N CCA und eine Belastungszeit $T_{Load}$ bereitstellt;
**dass** der Mikroprozessor (20) einen strategischen Entscheidungsprozess darin speichert;
**dass** ein Schalter (211), elektronisch verbunden zwischen einem der Ermittlungsdrähte (12) und der Belastungseinheit (21) und gesteuert durch den Mikroprozessor (20) vorhanden ist, und
**dass** die Einheit (22) zur Ermittlung des Batterieleistungszustandes elektronisch mit dem Mikroprozessor (20) verbunden ist, um eine Spannung und einen Strom der Batterie (30) zu ermitteln und die Spannung und den Strom dem Mikroprozessor (20) mitzuteilen;
wobei der Mikroprozessor (20) dazu angepasst ist, die folgenden Schritte des strategischen Entscheidungsprozesses durchzuführen:

(a) Erhalten von Kaltstartstromstärken $CCA_B$ von der Eingabevorrichtung, der Batteriespannung ($V_B$) einer vorliegenden Batterie von der Einheit (22) zur Ermittlung des Batterieleistungszustandes, der 1/N CCA und der Belastungszeit $T_{LOAD}$ von der Eingabevorrichtung (11) (S10);
(b) Verbinden der Belastungseinheit (21) mit der Batterie (30), und dann Auslesen des Batteriestroms $I_B$ der Batterie (30) aus der Einheit (22) zur Ermittlung des Batterieleistungszustandes (S11);
(c) Berechnen einer Gleichung der Belastungszeit mit dem Batteriestrom $I_B$, der Kaltstart-Stromstärke $CCA_B$, der 1/N CCA und der Belastungszeit $T_{LOAD}$, um eine endgültige Belastungszeit für die vorliegende Batterie (30) (S12) zu bestimmen, wobei die

Gleichung $\frac{(CCA_B \times \sqrt[1]{N})}{I_B} \times T_{LOAD}$ , ist, und

(d) Ausführen eines Ermittlungsvorgangs, um eine Ermittlungs-Wellenform (S 13) zu erhalten.

2. Batterietestgerät gemäß Anspruch 1, wobei der Mikroprozessor (20) ferner einen Ermittlungsvorgang speichert und dazu angepasst ist, die folgenden Schritte des Ermittlungsvorgangs auszuführen:

(a) Aufladen der Batterie (30) zu voller Kapazität und dann die Batterie (30) von einem Ladegerät (S20) entfernen;

(b) Anschließen der Belastungseinheit (21), um die Batterie (30) zu entladen, und Kontrollieren des Entladungsleistungszustandes (S20),

(c) Trennen der Belastungseinheit (21) von der Batterie (30), bis eine vorliegende Leistung der Batterie (30) niedriger als ein Leistungsschwellwert (S20) ist;

(d) alternativ Verbinden der Belastungseinheit (21) mit der Batterie (30), um mehrere Spannungswerte und Stromwerte der Batterie (30) (S21) zu ermitteln; und

(e) Vervollständigen der Ermittlungs-Wellenform mit den Spannungswerten und Stromwerten (S22).

**3.** Batterietestgerät gemäß Anspruch 2, wobei das Gehäuse (10) ferner eine Anzeigevorrichtung (13), eine Computerschnittstelle (14) und eine Alarmvorrichtung (15) aufweist.

## Revendications

**1.** Testeur de batterie, comportant un boîtier (10) avec un dispositif d'entrée (11), deux fils de détection (12), adaptés à être reliés à deux électrodes (31) d'une batterie (30) au choix, un microprocesseur (20), une unité de mise en charge électrique (21) électroniquement reliée au microprocesseur (20) et reliée aux fils de détection (12), et une unité (22) de détection de la condition de puissance de batterie, **caractérisé en ce:**

> **que** le dispositif d'entrée (11) fournit des options différentes de courants de démarrage à froid CCAB de la batterie (30) et des exigences de détection y enclos un 1/N CCA et une durée de chargement $T_{LOAD}$;
> **que** le microprocesseur (20) mémorise un procès de décision stratégique;
> **qu'**il y a un interrupteur (211), électroniquement raccordé entre un des fils de détection (12) et l'unité de mise en charge électrique (21) et commandé par le microprocesseur (20), et
> **que** l'unité (22) de détection de la condition de puissance de batterie est électroniquement reliée au microprocesseur (20) afin de détecter une tension et un courant de la batterie (30) et de communiquer la tension et le courant au microprocesseur (20);
> le microprocesseur (20) étant adapté à exécuter les étapes suivantes du procès de décision stratégique:

> (a) obtenir des courants de démarrage à froid $CCA_B$ du dispositif d'entrée, la tension de batterie ($V_B$) d'une présente batterie de l'unité (22) de détection de la condition de puissance de batterie, le 1/N CCA et la durée de mise en charge électrique $T_{LOAD}$ du dispositif d'entrée (11) (S 10);

(b) relier l'unité de mise en charge électrique (21) à la batterie (30), et puis lire le courant de batterie $I_B$ de la batterie (30) de l'unité (22) de détection de la condition de puissance de batterie (S11);

(c) calculer une équation de la durée de mise en charge électrique avec le courant de batterie $I_B$, le courant de démarrage à froid $CCA_B$, le 1/N CCA et la durée de mise en charge électrique $T_{LOAD}$, afin de déterminer une durée de mise en charge électrique définitive pour la présente batterie (30) (S12)

l'équation étant $\dfrac{(CCA_B \times \frac{1}{N})}{I_B} \times T_{LOAD}$, et

(d) exécuter un procédé de détection pour obtenir une forme de l'onde de détection (S13).

**2.** Testeur de batterie selon la revendication 1, dans lequel le microprocesseur (20) mémorise en outre un procédé de détection et est adapté à exécuter les étapes suivantes du procédé de détection:

> (a) charger la batterie (30) à pleine capacité et puis enlever la batterie (30) d'un chargeur (S20);
> (b) raccorder l'unité de mise en charge électrique (21) pour décharger la batterie (30), et surveiller la condition de la puissance de déchargement (S20),
> (c) séparer l'unité de mise en charge électrique (21) de la batterie (30), jusqu'à ce qu'une puissance de la batterie présente (30) et plus basse qu'une valeur de seuil de puissance (S20);
> (d) alternativement, raccorder l'unité de mise en charge électrique (21) à la batterie (30) pour détecter plusieurs valeurs de tension et valeurs de courant de la batterie (30) (S21); et
> (e) compléter la forme de l'onde de détection avec les valeurs de tension et les valeurs de courant (S22).

**3.** Testeur de batterie selon la revendication 2, dans lequel le boîtier (10) comporte en outre un dispositif d'affichage (13), un connecteur d'ordinateur (14) et un dispositif d'alarme(15).

FIG.1

FIG. 2

OBTAINING CCA$_B$ INPUTTED FROM THE INPUT DEVICE, THE BATTERY VOLTAGE (V$_B$) OF A PRESENT BATTERY FROM THE BATTERY POWER STATUS UNIT, AND A 1/N CCA AND A LOADING TIME INPUTTED FROM THE INPUT DEVICE ⟋ S10

CONNECTING THE LOADING UNIT TO THE BATTERY AND THEN READING THE BATTERY CURRENT I$_B$ OF THE BATTERY FROM THE BATTERY POWER STATUS DETECTING UNIT ⟋ S11

calculating an equation of loading time with the battery current I$_B$, the CCA$_B$, the 1/N CCA and the loading time (T$_{LOAD}$) to determine a final loading time for the present battery, wherein the equation is

$$\frac{(CCA_B \times \frac{1}{N})}{I_B} \times T_{LOAD}$$

⟋ S12

EXECUTING A DETECTING PROCESS TO OBTAIN A DETECTING WAVEFORM ⟋ S13

FIG. 3

FIG. 4

EP 2 506 023 B1

S40

CHARGING THE BATTERY TO FULL CAPACITY, CONNECTING THE VARIABLE LOADING UNIT TO DISCHARGE THE BATTERY AND MONITORING THE DISCHARGING POWER STATUS, AND DISCONNECTING THE VARIABLE LOADING UNIT FROM THE BATTERY UNTIL THE BATTERY DISCHARGES TO A PRESENT DISCHARGING POWER VALUE

S41

ALTERNATIVELY CONNECTING THE VARIABLE LOADING UNIT TO THE BATTERY TO DETECT MULTIPLE VOLTAGE VALUES AND CURRENT VALUES OF THE BATTERY

S42

COMPLETING THE DETECTING WAVEFORM BY THE VOLTAGE VALUES AND CURRENT VALUES

FIG. 5

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2006244423 A1
- US 6369577 B1
- US 6259254 B1
- US 5773977 A
- US 4707795 A
- US 2009237086 A1